# FASCICULE DE BREVET EUROPEEN

(11) **EP 2 955 765 B1**
(45) Date de publication et mention de la délivrance du brevet: **16.05.2018**
(21) Numéro de dépôt: 15170621.5
(22) Date de dépôt: 03.06.2015
(51) Int. Cl.: H01L 35/04

(54) **DISPOSITIF THERMOÉLECTRIQUE, MODULE THERMOÉLECTRIQUE COMPRENANT UN TEL DISPOSITIF THERMOÉLECTRIQUE ET PROCÉDÉ DE FABRICATION D'UN TEL DISPOSITIF THERMOÉLECTRIQUE**
Thermoelektrische Vorrichtung, thermoelektrisches Modul mit thermoelektrischer Vorrichtung und Verfahren zur Herstellung einer solchen Vorrichtung
THERMOELECTRIC DEVICE, THERMOELECTRIC MODULE INCLUDING SUCH THERMOELECTRIC DEVICE AND METHOD FOR PRODUCING SUCH A THERMOELECTRIC DEVICE

(30) Priorité: 10.06.2014 FR 1455214
(43) Date de publication de la demande: 16.12.2015
(73) Titulaire: VALEO SYSTEMES THERMIQUES, 78321 Le Mesnil Saint-Denis Cedex (FR); Simonin, Michel, 78960 Voisins le Bretonneux (FR)
(72) Inventeur: Simonin, Michel, 78960 Voisins-Le-Bretonneux (FR); De Vaulx, Cédric, 78770 AUTOUILLET (FR)
(74) Mandataire: Gevers & Orès

(56) Documents cités:
- EP-A1- 1 780 807
- FR-A1- 2 732 819
- FR-A1- 2 976 124
- US-A1- 2005 217 714
- US-A1- 2013 340 803

## Description

L'invention concerne un dispositif thermoélectrique, un module thermoélectrique comprenant un tel dispositif thermoélectrique et un procédé de fabrication d'un tel dispositif thermoélectrique.

Dans le domaine automobile, il a déjà été proposé (voir par exemple FR2732819 ou US2005/0217714) des dispositifs thermoélectriques utilisant des éléments, dits thermoélectriques, permettant de générer un courant électrique en présence d'un gradient de température entre deux de leurs faces opposées, dites faces actives, selon le phénomène connu sous le nom d'effet Seebeck. Ces dispositifs comprennent un premier circuit, destiné à la circulation des gaz d'échappement d'un moteur, et un deuxième circuit, destiné à la circulation d'un fluide caloporteur d'un circuit de refroidissement. Les éléments thermoélectriques sont disposés entre le premier et le deuxième circuit de façon à être soumis à un gradient de température provenant de la différence de température entre les gaz d'échappement, chauds, et le fluide de refroidissement, froid.

Les modules électriques comprennent des pistes électriques disposées sur les faces actives des éléments thermoélectriques afin de transmettre l'électricité d'une face active d'un élément thermoélectrique à une face active d'un autre élément thermoélectrique. Il est connu de prévoir ces pistes électriques sur l'ensemble des faces actives des éléments thermoélectriques. Cela présente l'inconvénient de constituer des tampons thermiques entre les éléments thermoélectriques et les sources thermiques, chaudes et froides.

L'invention propose d'améliorer la situation tout en évitant de court-circuiter tout ou partie les éléments thermoélectriques.

Ainsi, l'invention concerne un dispositif thermoélectrique comprenant au moins deux éléments thermoélectriques, dits premier et deuxième éléments thermoélectriques, susceptibles de générer un courant électrique sous l'action d'un gradient de température exercé entre deux de leurs faces, dites première et seconde faces actives, les premières faces actives étant destinées à échanger thermiquement avec une source chaude du gradient de température, et les deuxièmes faces actives étant destinées à échanger thermiquement avec une source froide du gradient de température.

Selon l'invention, ledit dispositif comprend un premier connecteur électrique connectant électriquement les deux éléments thermoélectriques, ledit premier connecteur recouvrant une première partie de chaque première, respectivement chaque seconde, face active desdits premier et deuxième éléments thermoélectriques, une seconde partie desdites premières, respectivement secondes, faces actives étant laissée libre.

La connexion électrique entre les éléments thermoélectriques du dispositif de l'invention se fait ainsi par un connecteur qui ne recouvre que partiellement chaque première face active desdits éléments thermoélectriques. Cela permet de palier à l'inconvénient des tampons thermiques entre les éléments thermoélectriques et les sources thermiques sans cependant créer de risque de court-circuit.

Selon différents modes de réalisation de l'invention, qui pourront être pris ensembles ou séparément :
- le premier élément thermoélectrique et le deuxième élément thermoélectrique sont configurés de sorte qu'une différence de potentiel électrique générée par le premier élément thermoélectrique soit opposée, vis-à-vis du gradient de température, à une différence de potentiel électrique générée par le deuxième élément thermoélectrique,
- ledit premier connecteur connecte électriquement les deux éléments thermoélectriques en série,
- ledit premier connecteur électrique est situé à cheval entre un bord du premier élément thermoélectrique et un bord voisin du second élément thermoélectrique,
- lesdits bords des premier et second éléments thermoélectriques recouverts par ledit premier connecteur électrique sont des épaulements,
- lesdites premières et deuxièmes faces actives sont reliées entre elles par au moins une face latérale, dite face latérale de liaison,
- le dispositif selon l'invention comprend un élément électriquement isolant recouvrant l'ensemble de chaque face latérale de liaison des premier et second éléments thermoélectriques en vis-à-vis, notamment au droit dudit premier connecteur,
- les secondes parties périphériques extérieures desdits premier et second éléments thermoélectriques, libres dudit premier connecteur électrique, portent des éléments d'échange thermique secondaires dites ailettes d'échange thermique, destinées à échanger thermiquement avec la source chaude du gradient de température,
- le dispositif selon l'invention comprend un deuxième connecteur électrique destiné à connecter en série un des deux éléments thermoélectriques du dispositif avec un troisième élément thermoélectrique dudit dispositif,
- ledit premier connecteur est situé au niveau de l'une des faces actives des premier et second éléments thermoélectriques et ledit deuxième connecteur électrique est situé à cheval entre un bord de l'autre face active de l'élément thermoélectrique auquel ledit troisième élément thermoélectrique est connecté et un bord de la face active correspondante du troisième élément thermoélectrique,
- les éléments thermoélectriques dudit dispositif présentent deux à deux une forme symétrique par rapport à leur face de liaison,
- les éléments thermoélectriques sont de forme annulaire,
- ledit épaulement est annulaire,
- ledit premier connecteur électrique est monté au niveau d'une portion axiale d'une périphérie extérieure desdits éléments thermoélectriques,
- ledit deuxième connecteur électrique est monté au niveau d'une portion axiale d'une périphérie intérieure desdits éléments thermoélectriques,
- les éléments isolants sont de forme annulaire,
- le connecteur électrique est une bague, en particulier située au niveau dudit épaulement,
- le dispositif selon l'invention comprend un second élément électriquement isolant recouvrant l'ensemble des faces latérales de liaison de l'élément thermoélectrique auquel ledit troisième élément thermoélectrique est connecté et dudit troisième élément thermoélectrique,
- les éléments thermoélectriques, les connecteurs électriques et/ou les éléments isolants sont coaxiaux.

Avantageusement, un tube est inséré à l'intérieur des éléments thermoélectriques. Ce tube est prévu coaxial avec les éléments thermoélectriques et les éléments isolants.

Ce tube sera, avantageusement, en aluminium anodisé.

Ce tube a pour fonction la circulation d'un fluide réfrigérant constituant la source froide dudit gradient de température, à l'intérieur du module thermoélectrique de l'invention.

L'invention concerne aussi un module thermoélectrique comprenant une pluralité de dispositifs thermoélectriques tels que celui décrit ci-dessus.

L'invention concerne encore un procédé de fabrication d'un dispositif thermoélectrique tel que décrit ci-dessus, dans lequel on brase le premier connecteur électrique sur chaque première face active desdits premier et deuxième éléments thermoélectriques.

L'invention sera mieux comprise, et d'autres buts, détails, caractéristiques et avantages de celle-ci apparaîtront plus clairement au cours de la description explicative détaillée qui va suivre, d'au moins un mode de réalisation de l'invention donné à titre d'exemple purement illustratif et non limitatif, en référence aux dessins schématiques annexés.

Sur ces dessins :
- la figure 1 illustre schématiquement en perspective et de façon éclatée un premier et un deuxième éléments thermoélectriques d'un dispositif thermoélectrique selon l'invention,
- la figure 2 illustre une vue des deux éléments de la figure 1 avec un connecteur électrique et un élément isolant complétant le dispositif selon l'invention,
- la figure 3 illustre les éléments de la figure 2 une fois assemblés,
- la figure 4 illustre les éléments de la figure 3 avec, en vue éclatée, des ailettes d'échange thermique complétant le dispositif selon l'invention,
- la figure 5 illustre une version assemblée des éléments de la figure 4,
- la figure 6 illustre une coupe longitudinale de la figure 5,
- la figure 7 illustre deux paires d'éléments thermoélectriques selon la figure 5, destinées à être reliées par un deuxième connecteur électrique,
- la figure 8 illustre un dispositif thermoélectrique conforme à l'invention se présentant sous la forme d'un crayon d'éléments thermoélectriques.

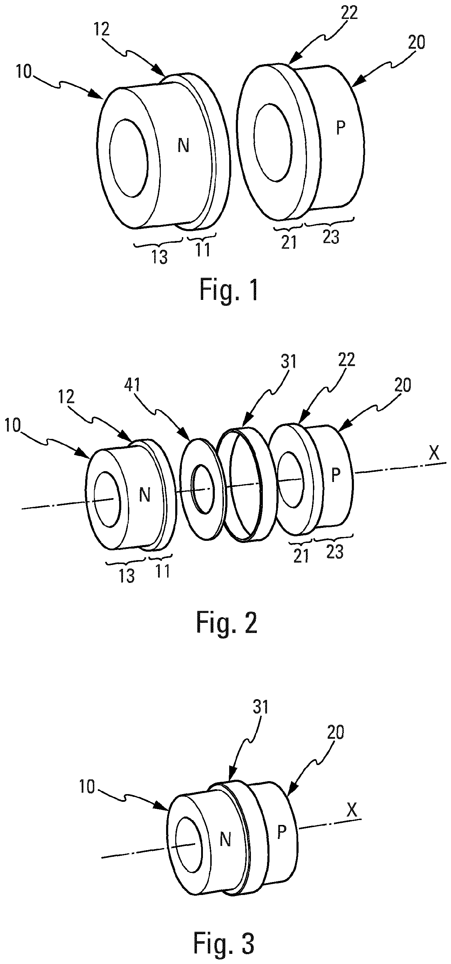

L'invention concerne un dispositif thermoélectrique comprenant au moins deux éléments thermoélectriques repérés 10, 20 sur les figures 1 à 6. Ils portent l'inscription N et P sur les figures pour caractériser leur différence de comportement électrique face à un même gradient de température. En effet, le premier élément thermoélectrique 10, portant l'inscription N, sera configuré de telle sorte que la différence de potentiel électrique qu'il génère soit opposée, vis-à-vis du gradient de température, à la différence de potentiel électrique générée par le deuxième élément thermoélectrique 20, portant l'inscription P.

Plus précisément, ces premier et deuxième éléments thermoélectriques 10, 20 sont susceptibles de générer un courant électrique sous l'action d'un gradient de température exercé entre deux de leurs faces, dites première et seconde faces actives. Les premières faces actives sont destinées, dans l'exemple ici illustré, à échanger thermiquement avec une source chaude du gradient de température, et les deuxièmes faces actives avec une source froide de ce gradient de température.

Dans l'exemple de réalisation illustré ici, les éléments thermoélectriques 10, 20 sont annulaires : ils se présentent sous la forme de cylindres creux. Sur la figure 1, la première face active, celle destinée à échanger thermiquement avec la source chaude, est la face externe du cylindre. La deuxième face active, celle destinée à échanger avec la source froide, est la face interne dudit cylindre creux.

Lesdites première et seconde faces sont, par exemple, de section ovales pour les premières et/ou circulaires pour les secondes. De façon plus générale, toute section de forme arrondie et/ou polygonale est possible.

De tels éléments fonctionnent, selon l'effet Seebeck, en permettant de créer un courant électrique dans une charge connectée entre lesdites faces soumises au gradient de température. De façon connue de l'homme du métier, de tels éléments sont constitués, par exemple, de Bismuth et de Tellurium (Bi2Te3).

Aux figures 1 à 8, les éléments thermoélectriques 10, 20 représentés sont constitués d'un anneau en seule pièce. Ils pourront cependant être formés de plusieurs pièces formant chacune une portion angulaire de l'anneau.

La première surface présente, par exemple, un rayon compris entre 1,5 et 4 fois le rayon de la seconde surface. Il pourra s'agir d'un rayon égal à environ 2 fois celui de seconde surface.

Lesdits éléments thermoélectriques présentent, par exemple, deux faces planes parallèles opposées. Autrement dit, l'anneau constituant l'élément thermoélectrique est de section annulaire rectangulaire.

De plus, chacun desdits cylindres creux présente un épaulement 12, 22 sur sa face externe. Ledit épaulement 12, 22 s'étend ici de façon annulaire sur la périphérie de chacun desdits éléments thermoélectriques 10, 20.

Les éléments thermoélectriques 10, 20 de l'invention présentent, en outre, chacun deux parties 11, 13, 21, 23 cylindriques ici situées dans le prolongement axial l'une de l'autre, en continuité. Ces parties 11, 13, 21, 23 peuvent être définies pour chaque face active, que cette face soit externe - en contact avec la source chaude, ou interne - en contact avec la source froide.

Comme cela est illustré à la figure 2, le dispositif selon l'invention comprend un premier connecteur électrique 31 connectant électriquement les deux éléments thermoélectriques 10, 20. Ce premier connecteur 31 recouvre la première partie 11, 21 de chaque première face active desdits premier 10 et deuxième 20 éléments thermoélectriques. Ainsi ledit premier connecteur 31 connecte électriquement les deux éléments thermoélectriques, notamment en série.

La figure 2 illustre aussi le fait que les faces actives sont reliées entre elles par au moins une face latérale, dite face latérale de liaison 41, électriquement isolante afin d'éviter tout court-circuit entre lesdits éléments thermoélectriques 10, 20. Les éléments thermoélectriques sont prévus coaxiaux, le long de l'axe repéré X sur les figures ; lesdits éléments isolants aussi, le long du même axe X.

La figure 3 illustre ledit premier connecteur électrique 31 qui est situé à cheval entre le bord 12 du premier élément thermoélectrique 10 et le bord voisin 22 du second élément thermoélectrique 20, ceci en recouvrant les épaulements 12, 22 décrits ci-dessus.

Ledit connecteur 31 pourra en particulier présenter la forme d'une bague. Il est aussi conçu pour contribuer à, voire assurer la liaison mécanique entre lesdits éléments thermoélectriques 10, 20, en particulier grâce au procédé d'assemblage décrit par la suite.

Selon l'invention la seconde partie 13, 23 desdites premières faces actives est laissée libre, le connecteur 31 ne recouvrant que la première partie 11, 21. Cette seconde partie 13, 23 peut de la sorte être plus en contact avec la source chaude.

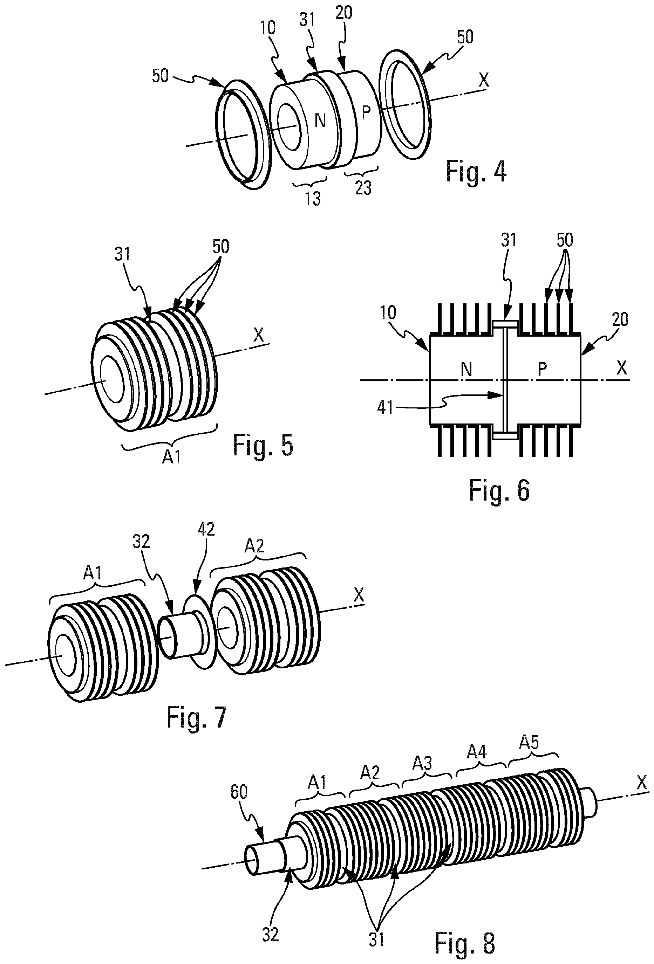

La figure 4 illustre l'assemblage d'ailettes 50 sur lesdites secondes parties périphériques extérieures 13, 23 desdits premier et second éléments thermoélectriques 10, 20. Ces ailettes 50 sont des éléments d'échange thermique secondaires destinées à échanger thermiquement avec la source chaude du gradient de température. L'assemblage obtenu est illustré aux figures 5 et 6.

La figure 6 illustre de manière détaillée cet assemblage. C'est une vue en coupe de la figure 5. Sur cette figure, on constate que l'élément d'isolation 41 est pris en sandwich entre lesdits deux éléments 10, 20. Le connecteur électrique (et mécanique) 31 est, lui, positionné au niveau des épaulements des deux éléments 10, 20.

Le connecteur occupe une surface limitée de la périphérie externe desdits deux éléments 10, 20. C'est ainsi qu'une partie non négligeable de la face active destinée à entrer en contact avec la source chaude est laissée libre, en particulier pour y insérer lesdites ailettes 50 qui favorisent d'avantage l'échange thermique avec ladite source de chaleur.

La figure 7 illustre l'assemblage de la figure 5, repéré A1, avec un second assemblage identique, repéré A2. Ces assemblages A1, A2 sont connectés électriquement grâce à un deuxième connecteur électrique 32. Ce deuxième connecteur 32 est destiné à connecter en série un des deux éléments thermoélectriques de l'assemblage A1 avec un troisième élément thermoélectrique qui appartient au second assemblage illustré A2.

Comme le premier connecteur 31, ledit deuxième connecteur électrique 32 est situé à cheval entre un bord de l'autre face active de l'élément thermoélectrique 20 auquel ledit troisième élément thermoélectrique 10 est connecté. Ici, la face active concernée est la face interne desdits éléments thermoélectriques, celle destinée à entrer en contact avec la source froide. Comme pour la première liaison décrite ci-dessus, le dispositif de l'invention comprend un élément isolant 42. Ce second élément isolant 42 recouvre l'ensemble des faces latérales de liaison.

L'objectif est le même que précédemment : éviter tout court-circuit entre les éléments thermoélectriques ainsi assemblés.

La figure 8 illustre un assemblage de plusieurs assemblages A1-A6 tel que celui qui vient d'être décrit à l'aide de la figure 7. L'ensemble de ces assemblages A1-A6 forme ici un crayon thermoélectrique.

Avantageusement, un tube 60 est inséré à l'intérieur des éléments thermoélectriques 10, 20 de ce crayon thermoélectrique. Ce tube 60 est prévu coaxial avec les éléments thermoélectriques 10, 20 et les éléments isolants 41, 42. Il a pour fonction de permettre la circulation d'un fluide réfrigérant, en tant que source froide, à l'intérieur du module thermoélectrique de l'invention.

Ce tube sera, avantageusement, en aluminium anodisé, notamment expansé.

L'invention concerne aussi un module thermoélectrique comprenant une pluralité de dispositifs thermoélectriques tels que décrits plus haut de manière à former, par exemple, un générateur thermoélectrique.

Ledit module pourra en particulier comprendre un faisceau de crayons thermoélectriques.

L'invention concerne encore un procédé de fabrication d'un dispositif thermoélectrique tel que décrit ci-dessus, dans lequel on brase le premier connecteur électrique sur chaque première face active desdits premier et deuxième éléments thermoélectriques 10, 20. C'est cette opération de brasage qui permet aux connecteurs électriques 31, 32 d'assurer la liaison mécanique entre les éléments thermoélectriques 10, 20 tel que cela a été évoqué ci-dessus.

Il est à noter, à titre indicatif, que les ailettes 50 seront avantageusement montées à force sur la périphérie desdits premier et second éléments thermoélectriques 10, 20.

Ainsi, grâce au dispositif de l'invention, la connexion électrique entre les éléments thermoélectriques 10, 20 d'un crayon thermoélectrique est réalisée sans introduire de résistance thermique entre la source chaude et lesdits éléments thermoélectriques.

La quantité de matière thermoélectrique disponible pour échanger thermiquement, en particulier avec la source chaude, est ainsi optimisée, et par conséquent, la production de puissance électrique.

## Revendications

1. Dispositif thermoélectrique comprenant au moins deux éléments thermoélectriques (10, 20), dits premier (10) et deuxième éléments thermoélectriques (20), susceptibles de générer un courant électrique sous l'action d'un gradient de température exercé entre deux de leurs faces, dites première et seconde faces actives, les premières faces actives étant destinées à échanger thermiquement avec une source chaude du gradient de température, et les deuxièmes faces actives étant destinées à échanger thermiquement avec une source froide du gradient de température, ledit dispositif comprenant un premier connecteur électrique (31) connectant électriquement les deux éléments thermoélectriques (10, 20), **caractérisé en ce que** ledit premier connecteur (31) recouvrant une première partie (11, 21) de chaque première, respectivement chaque seconde, face active desdits premier (10) et deuxième éléments thermoélectriques (20), une seconde partie (13, 23) desdites premières, respectivement secondes, faces actives étant laissée libre.

2. Dispositif selon la revendication précédente, dans lequel ledit premier connecteur électrique (31) est situé à cheval entre un bord (12) du premier élément thermoélectrique (10) et un bord voisin (22) du second élément thermoélectrique (20).

3. Dispositif thermoélectrique selon la revendication précédente, dans lequel lesdits bords (12, 22) des premier (10) et second éléments thermoélectriques (20) recouverts par ledit premier connecteur électrique (31) sont des épaulements (12, 22).

4. Dispositif selon l'une quelconque des revendications précédentes, dans lequel lesdites premières et deuxièmes faces actives sont reliées entre elles par au moins une face latérale, dite face latérale de liaison, ledit dispositif comprenant un élément électriquement isolant (41, 42) recouvrant l'ensemble de chaque face latérale de liaison des premier (10) et second éléments thermoélectriques (20) en vis-à-vis.

5. Dispositif selon l'une quelconque des revendications précédentes, dans lequel les secondes parties périphériques extérieures (13, 23) desdits premier (10) et second éléments thermoélectriques (20), libres dudit premier connecteur électrique, portent des éléments d'échange thermique secondaires dites ailettes d'échange thermique (50), destinées à échanger thermiquement avec la source chaude du gradient de température.

6. Dispositif selon l'une quelconque des revendications précédentes, comprenant un deuxième connecteur électrique (32) destiné à connecter en série un des deux éléments thermoélectriques (10, 20) du dispositif avec un troisième élément thermoélectrique (10, 20) dudit dispositif.

7. Dispositif selon la revendication précédente, dans lequel ledit premier connecteur (31) est situé au niveau de l'une des faces actives des premier (10) et second éléments thermoélectriques (20) et ledit deuxième connecteur électrique (32) est situé à cheval entre un bord (12, 22) de l'autre face active de l'élément thermoélectrique (10, 20) auquel ledit troisième élément thermoélectrique (10, 20) est connecté et un bord (12, 22) de la face active correspondante du troisième élément thermoélectrique (10, 20).

8. Dispositif selon l'une quelconque des revendications précédentes, dans lequel les éléments thermoélectriques (10, 20) sont de forme annulaire.

9. Dispositif selon la revendication précédente, dans lequel le connecteur électrique (31, 32) est une bague.

10. Module thermoélectrique comprenant une pluralité de dispositifs thermoélectriques (A1-A6) selon l'une quelconque des revendications précédentes.

11. Procédé de fabrication d'un dispositif thermoélectrique selon l'une quelconque des revendications 1 à 10, dans lequel on brase le premier connecteur (31) sur chaque première face active desdits premier (10) et deuxième éléments thermoélectriques (20).

## Patentansprüche

1. Thermoelektrische Vorrichtung, die mindestens zwei, als erstes (10) und zweites thermoelektrisches Element (20) bezeichnete thermoelektrische Elemente (10, 20) umfasst, welche in der Lage sind, unter der Einwirkung eines Temperaturgradienten, der zwischen zwei ihrer als erste und zweite aktive Flächen bezeichneten Flächen ausgeübt wird, einen elektrischen Strom zu erzeugen, wobei die ersten aktiven Flächen dazu bestimmt sind, sich wärmemäßig mit einer Wärmequelle des Temperaturgradienten auszutauschen, und die zweiten aktiven Flächen dazu bestimmt sind, sich wärmemäßig mit einer Kältequelle des Temperaturgradienten auszutauschen, wobei die Vorrichtung einen ersten elektrischen Verbinder (31) umfasst, der die zwei thermoelektrischen Elemente (10, 20) elektrisch verbindet, **dadurch gekennzeichnet, dass** der erste Verbinder (31) einen ersten Teil (11, 21) jeder ersten beziehungsweise jeder zweiten aktiven Fläche des ersten (10) und zweiten thermoelektrischen Elements (20) bedeckt, wobei ein zweiter Teil (13, 23) der ersten beziehungsweise zweiten aktiven Flächen freigelassen ist.

2. Vorrichtung nach dem vorstehenden Anspruch, wobei der erste elektrische Verbinder (31) rittlings zwischen einer Kante (12) des ersten thermoelektrischen Elements (10) und einer benachbarten Kante (22) des zweiten thermoelektrischen Elements (20) liegt.

3. Thermoelektrische Vorrichtung nach dem vorstehenden Anspruch, wobei die Kanten (12, 22) des ersten (10) und zweiten thermoelektrischen Elements (20), die von dem ersten elektrischen Verbinder (31) bedeckt sind, Schultern (12, 22) sind.

4. Vorrichtung nach einem der vorstehenden Ansprüche, wobei die ersten und zweiten aktiven Flächen durch mindestens eine, als seitliche Koppelfläche bezeichnete Seitenfläche miteinander gekoppelt sind, wobei die Vorrichtung ein elektrisch isolierendes Element (41, 42) umfasst, das die Gesamtheit jeder seitlichen Koppelfläche des ersten (10) und zweiten thermoelektrischen Elements (20), die einander zugewandt sind, bedeckt.

5. Vorrichtung nach einem der vorstehenden Ansprüche, wobei die zweiten äußeren Umfangsteile (13, 23) des ersten (10) und zweiten thermoelektrischen Elements (20), welche von dem ersten elektrischen Verbinder frei sind, als Wärmeaustauschrippen (50) bezeichnete sekundäre Wärmeaustauschelemente tragen, die dazu bestimmt sind, sich wärmemäßig mit der Wärmequelle des Temperaturgradienten auszutauschen.

6. Vorrichtung nach einem der vorstehenden Ansprüche, umfassend einen zweiten elektrischen Verbinder (32), der dazu bestimmt ist, eines der zwei thermoelektrischen Elemente (10, 20) der Vorrichtung mit einem dritten thermoelektrischen Element (10, 20) der Vorrichtung in Reihe zu schalten.

7. Vorrichtung nach dem vorstehenden Anspruch, wobei der erste Verbinder (31) im Bereich von einer der aktiven Flächen des ersten (10) und zweiten thermoelektrischen Elements (20) liegt, und der zweite elektrische Verbinder (32) rittlings zwischen einer Kante (12, 22) der anderen aktiven Fläche des thermoelektrischen Elements (10, 20), mit dem das dritte thermoelektrische Element (10, 20) verbunden ist, und einer Kante (12, 22) der entsprechenden aktiven Fläche des dritten thermoelektrischen Elements (10, 20) liegt.

8. Vorrichtung nach einem der vorstehenden Ansprüche, wobei die thermoelektrischen Elemente (10, 20) von kreisförmiger Form sind.

9. Vorrichtung nach dem vorstehenden Anspruch, wobei der elektrische Verbinder (31, 32) ein Ring ist.

10. Thermoelektrisches Modul, das eine Vielzahl von thermoelektrischen Vorrichtungen (A1-A6) nach einem der vorstehenden Ansprüche umfasst.

11. Verfahren zum Herstellung einer thermoelektrischen Vorrichtung nach einem der Ansprüche 1 bis 10, wobei der erste Verbinder (31) auf jede erste aktive Fläche des ersten (10) und zweiten thermoelektrischen Elements (20) gelötet wird.

## Claims

1. Thermoelectric device comprising at least two thermoelectric elements (10, 20), called first (10) and second (20) thermoelectric elements, capable of generating an electric current under the action of a temperature gradient exerted between two of their faces, called first and second active faces, the first active faces being intended to undergo heat exchange with a hot source of the temperature gradient, and the second active faces being intended to undergo heat exchange with a cold source of the temperature gradient, said device comprising a first electrical connector (31) connecting the two thermoelectric elements (10, 20) electrically, **characterized in that** said first connector (31) covers a first part (11, 21) of each first, respectively each second, active face of said first (10) and second thermoelectric elements (20), a second part (13, 23) of said first, respectively second, active faces being left free.

2. Device according to the preceding claim, wherein said first electrical connector (31) is located straddling an edge (12) of the first thermoelectric element (10) and an adjacent edge (22) of the second thermoelectric element (20).

3. Thermoelectric device according to the preceding claim, wherein said edges (12, 22) of the first (10) and second (20) thermoelectric elements covered by said first electrical connector (31) are shoulders (12, 22).

4. Device according to any one of the preceding claims, wherein said first and second active faces are connected together by at least one lateral face, called lateral connecting face, said device comprising an electrically insulating element (41, 42) covering the whole of each lateral connecting face of the first (10) and second (20) thermoelectric elements opposite one another.

5. Device according to any one of the preceding claims, wherein the second outer peripheral portions (13, 23) of said first (10) and second (20) thermoelectric elements, free from said first electrical connector, bear secondary heat exchange elements called heat exchange fins (50), intended to undergo heat exchange with the hot source of the temperature gradient.

6. Device according to any one of the preceding claims, comprising a second electrical connector (32) intended to connect in series one of the two thermoelectric elements (10, 20) of the device to a third thermoelectric element (10, 20) of said device.

7. Device according to the preceding claim, wherein said first connector (31) is located at the level of one of the active faces of the first (10) and second (20) thermoelectric elements and said second electrical connector (32) is located straddling an edge (12, 22) of the other active face of the thermoelectric element (10, 20) to which said third thermoelectric element (10, 20) is connected and an edge (12, 22) of the corresponding active face of the third thermoelectric element (10, 20).

8. Device according to any one of the preceding claims, wherein the thermoelectric elements (10, 20) are of annular shape.

9. Device according to the preceding claim, wherein the electrical connector (31, 32) is a ring.

10. Thermoelectric module comprising a plurality of thermoelectric devices (A1-A6) according to any one of the preceding claims.

11. Method for manufacturing a thermoelectric device according to any one of claims 1 to 10, wherein the first connector (31) is soldered on each first active face of said first (10) and second (20) thermoelectric elements.
